# DEMANDE DE BREVET EUROPEEN

(11) **EP 2 204 877 A1**
(43) Date de publication de la demande: **07.07.2010**
(21) Numéro de dépôt: 09180773.5
(22) Date de dépôt: 24.12.2009
(51) Int. Cl.: H01P 5/10, H03H 7/42, H01F 17/00

(54) **Réglage d'un transformateur à changement de mode (balun)**

(30) Priorité: 30.12.2008 FR 0859110
(71) Demandeur: STMicroelectronics (Tours) SAS, 37100 Tours (FR)
(72) Inventeur: Laporte, Claire, 37000 Tours (FR); Ezzeddine, Hilal, 37100 Tours (FR)
(74) Mandataire: de Beaumont, Michel

(57) **Abrégé**

L'invention concerne un transformateur à changement de mode comportant : côté mode commun, un élément inductif (L1) en série avec un premier élément capacitif (C1) entre une borne (SE) d'accès de mode commun et la masse (GND) ; et côté mode différentiel, deux enroulements inductifs (L2) en série dont des premières extrémités respectives définissent des bornes (52, 53) d'accès différentiel et dont des secondes extrémités communes (55) sont connectées à la masse, des seconds éléments capacitifs (C2) étant respectivement connectés en parallèle sur les enroulements de mode différentiel.

## Description

### Domaine de l'invention

La présente invention concerne le domaine des transformateurs à changement de mode, habituellement appelés "balun" (de l'anglais balance-unbalance). De tels transformateurs sont destinés à convertir un signal de mode commun en un signal de mode différentiel et inversement, et à éviter des perturbations introduites par un plan de masse du circuit, un coupleur parasite, etc.

Des transformateurs à changement de mode équipent généralement des chaînes d'émission-réception radiofréquence. Ils sont chargés de convertir des signaux de mode commun reçus par une antenne en signaux différentiels exploitables par des circuits de traitement et, dans le sens inverse, de convertir des signaux différentiels à émettre en signal de mode commun à destination de l'antenne.

### Exposé de l'art antérieur

Un transformateur à changement de mode comporte un accès de mode commun, généralement du côté d'une antenne de communication, et deux accès de mode différentiel destinés à être connectés à des circuits de traitement de signaux reçus ou à émettre. Electriquement, le transformateur à changement de mode est équivalent à un montage inductif comportant des inductances couplées. Typiquement, une inductance (ou deux inductances en série) relient l'accès de mode commun à une borne en l'air ou reliée à la masse par un élément capacitif. Une inductance à point milieu ou deux inductances en série relient les accès de mode différentiel, le point milieu de cette association en série étant généralement connecté à la masse.

Les baluns se répartissent en trois catégories. Une première catégorie concerne les baluns dits distribués, constitués de lignes de transmission couplées les unes aux autres. Une deuxième catégorie concerne les baluns dits actifs, constitués de transistors. Une troisième catégorie concerne les baluns dits à éléments localisés, constitués de composants inductifs et le cas échéant capacitifs discrets. La présente invention concerne les baluns distribués de la première catégorie.

Les caractéristiques que l'on souhaite respecter sont de faibles pertes d'insertion, une bonne adaptation d'impédance et des déséquilibres minimum de phase et d'amplitude entre les voies différentielles.

Lorsque le balun est associé à une chaîne d'émission, on trouve généralement en amont un oscillateur fournissant une fréquence à un modulateur des données à transmettre. L'oscillateur (typiquement, un oscillateur commandé en tension - VCO) fournit généralement un signal à une fréquence multiple (généralement le double ou la moitié) de la fréquence de la porteuse (du signal utile).

Les circuits connectés en aval du modulateur sont généralement dimensionnés en fonction de la fréquence centrale de la bande utile. Par conséquent, leur impédance à une autre fréquence n'est généralement pas optimisée.

En cas de variation de l'impédance vue par l'oscillateur, l'oscillateur est susceptible de subir une dérive en fréquence. Ce phénomène est généralement appelé "pulling" en anglais. Or, dans une chaîne de transmission, une variation de la fréquence de l'oscillateur engendre une variation de la fréquence de la porteuse.

En théorie, il faudrait que le balun présente une impédance donnée à la fréquence du signal utile et une autre impédance donnée à la fréquence de l'oscillateur. Ces deux critères sont le plus souvent imcompatibles avec les structures usuelles de balun.

Le document US-A-2008/303606 décrit un balun large bande dans lequel l'enroulement de mode commun est en série avec un condensateur placé entre la borne d'application du signal et l'enroulement, l'autre extrémité de l'enroulement de mode commun étant directement connectée à la masse.

### Résumé

La présente invention vise à proposer un transformateur à changement de mode, de type à lignes distribuées, qui pallie tout ou partie des inconvénients des transformateurs usuels.

L'invention vise plus particulièrement à proposer une structure de transformateur à changement de mode qui permet d'obtenir deux impédances différentes pour deux fréquences différentes.

L'invention vise en outre une solution ne requérant aucune modification des circuits connectés en amont et en aval du transformateur à changement de mode.

Ainsi, un mode de réalisation de la présente invention prévoit un transformateur à changement de mode comportant :
côté mode commun, un élément inductif en série avec un premier élément capacitif entre une borne d'accès de mode commun et la masse, ledit élément capacitif étant connecté entre ledit élément inductif et la masse ; et
côté mode différentiel, deux enroulements inductifs en série dont des premières extrémités respectives définissent des bornes d'accès différentiel et dont des secondes extrémités communes sont connectées à la masse, et des seconds éléments capacitifs respectivement connectés en parallèle sur les enroulements de mode différentiel.

Selon un mode de réalisation de la présente invention, la valeur des seconds éléments capacitifs est choisie pour définir une impédance côté mode différentiel à une seconde fréquence différente d'une première fréquence approximativement centrée sur la bande passante.

Selon un mode de réalisation de la présente invention, la seconde fréquence correspond à la fréquence d'un oscillateur connecté côté mode différentiel.

Selon un mode de réalisation de la présente invention, les éléments inductifs sont réalisés sous la forme d'enroulements conducteurs plans.

Selon un mode de réalisation de la présente invention, la valeur du premier élément capacitif est choisie pour définir le rapport d'impédance entre les accès de mode commun et de mode différentiel à une première fréquence correspondant à la fréquence centrale de la bande passante.

Selon un mode de réalisation de la présente invention, les enroulements inductifs sont réalisés sous la forme de plusieurs enroulements interdigités et superposés dans deux niveaux conducteurs.

Il est également prévu un circuit de transmission radiofréquence comportant :
au moins une voie d'émission ou de réception incluant au moins un transformateur à changement de mode ;
au moins un oscillateur.

Il est également prévu un dispositif d'émission-réception comportant au moins un tel circuit.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une représentation schématique d'un dispositif d'émission-réception radiofréquence du type auquel s'applique à titre d'exemple la présente invention ;
la figure 2 est un schéma bloc détaillant des éléments d'un exemple de dispositif d'emission-réception radiofréquence multibande ;
la figure 3 représente schématiquement un exemple usuel de transformateur à changement de mode ;
la figure 4 représente le schéma électrique équivalent d'un mode de réalisation d'un transformateur à changement de mode ;
la figure 5 est un abaque de Smith illustrant le fonctionnement du transformateur de la figure 4 ;
la figure 6 représente un autre mode de réalisation d'un transformateur à changement de mode ; et
la figure 7 est une vue de dessus d'un exemple de réalisation du transformateur de la figure 6 en lignes distribuées.

De mêmes éléments ont été désignés par de mêmes références aux différentes figures.

### Description détaillée

Pour des raisons de clarté, seuls les éléments utiles à la compréhension de l'invention ont été représentés et seront décrits. En particulier, les circuits de génération des données à transmettre et d'exploitation des données reçues par le dispositif d'émission-réception décrit n'ont pas été détaillés, l'invention étant compatible avec les traitements usuels de génération et d'exploitation de ces données.

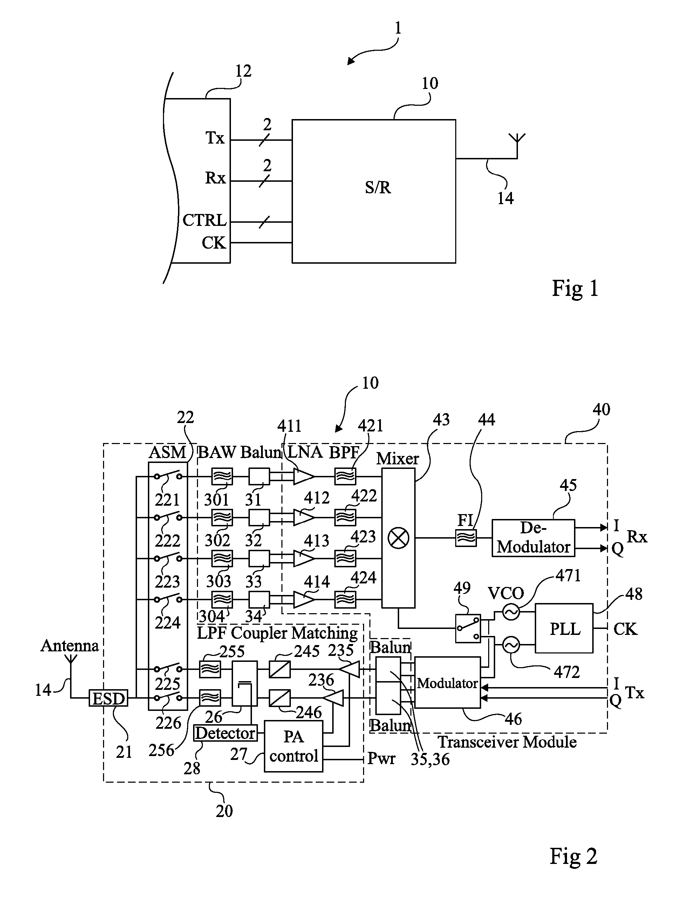

La figure 1 est une représentation schématique d'un dispositif 1 de communication utilisant un circuit 10 d'émission/réception radiofréquence (S/R). Le dispositif 1 comporte un ou plusieurs circuits 12 de génération de signaux à transmettre Tx et d'exploitation de signaux reçus Rx. Le circuit 10 reçoit, du circuit 12, les signaux différentiels Tx à transmettre, un ou plusieurs signaux de commande CTRL ainsi qu'un signal d'horloge CK ou de synchronisation, et transmet au circuit 12 les signaux différentiels Rx de réception. Le circuit 10 est relié à une ou plusieurs antennes 14.

Un dispositif tel qu'illustré par la figure 1 peut se retrouver, par exemple, dans des dispositifs de communication de type téléphonie mobile, assistant personnel (PDA), micro-ordinateur, etc.

La figure 2 est un schéma bloc plus détaillé d'un dispositif 10 d'émission-réception. Notamment pour un téléphone portable, un même dispositif est susceptible de fonctionner sur plusieurs bandes de fréquence en émission et en réception. Toutefois, l'invention s'applique également à un dispositif d'émission à bande unique.

Dans l'exemple représenté, le dispositif comporte deux voies d'émission et quatre voies de réception partageant une même antenne 14 (Antenna). L'antenne 14 est connectée à un circuit 20 réalisant des fonctions de commutation de voies et d'adaptation d'impédance en émission. L'extrémité de l'antenne 14 est connectée à une borne, de préférence équipée de moyens de protection contre des décharges électrostatiques (bloc 21, ESD). Le bloc 21 est relié à des premières bornes d'un commutateur multivoies analogique 22 (ASM) chargé de sélectionner une voie d'émission et une voie de réception par un réseau d'interrupteurs 221 à 226. Des secondes bornes des quatre interrupteurs 221 à 224 définissent les voies de réception. Chaque voie de réception comporte un filtre 301 à 304, par exemple un filtre à ondes de volume (BAW), suivi d'un transformateur à changement de mode 31 à 34 (Balun) convertissant le signal reçu en un signal différentiel. Les signaux différentiels sont alors amplifiés par des amplificateurs à faible bruit 411 à 414 (LNA) dont les sorties respectives sont traitées par des filtres 421 à 424 de type passe-bande (BPF) dont la bande passante dépend de la fréquence de la voie considérée. Les sorties des filtres 421 à 424 sont envoyées à un mélangeur 43 (Mixer). Le rôle du mélangeur est de convertir, en bande de base (fréquence intermédiaire), les signaux reçus. Il fournit un signal à la fréquence intermédiaire quelle que soit la voie. Ce signal est filtré par un filtre 44 passe-bande à la fréquence intermédiaire FI. La sortie du filtre 44 est exploitée par un démodulateur 45 (De-Modulator) fournissant, en quadrature de phase (bornes de sortie I et Q), le signal reçu Rx. Les amplificateurs à faible bruit 41, filtres passe-bande 42, mélangeur 43, filtre 44 et démodulateur 45 sont le plus souvent intégrés dans un circuit 40 constituant un module de transmission (Transceiver Module).

Côté émission, ce module 40 comporte un modulateur 46 (Modulator) recevant, en quadrature de phase (bornes d'entrée I et Q), le signal Tx à transmettre. Le modulateur 46 reçoit autant de porteuses qu'il y a de voies d'émission à des fréquences différentes. Dans l'exemple représenté, deux oscillateurs 471 et 472 commandés en tension (VCO) sont asservis par une boucle à verrouillage de phase 48 (PLL) recevant le signal d'horloge CK. Les sorties respectives des oscillateurs 471 et 472 sont d'une part envoyées au modulateur 46 et, d'autre part, par l'intermédiaire d'un sélecteur 49 au mélangeur 43 de la partie réception pour lui permettre la conversion en bande de base. En variante, un sélecteur non représenté est intercalé entre les oscillateurs et le modulateur 46.

Le modulateur 46 comporte autant de paires de sorties différentielles qu'il existe de voies d'émission. Chaque voie d'émission comporte un transformateur à changement de mode 35, 36 (Balun) dont la sortie de mode commun est amplifiée par un amplificateur 235, 236. Les sorties des amplificateurs 235 et 236 sont traitées par des circuits d'adaptation d'impédance 245 et 246 (Matching) dont les sorties respectives sont envoyées sur des filtres passe-bas 255 et 256 (LPF) après avoir traversé un coupleur 26 (Coupler). Le rôle du coupleur 26 est d'asservir la puissance des amplificateurs 235 et 236 au moyen d'un circuit d'asservissement 27 (PA control) recevant un signal de commande Pwr du circuit 12 et un signal représentatif de la puissance émise d'un détecteur 28 (Detector) prélevant une information relative à la puissance sur la ligne secondaire du coupleur 26. Les sorties respectives des filtres 255 et 256 sont envoyées sur des secondes bornes des interrupteurs 225 et 226.

Le fonctionnement du module de transmission de la figure 2 est usuel.

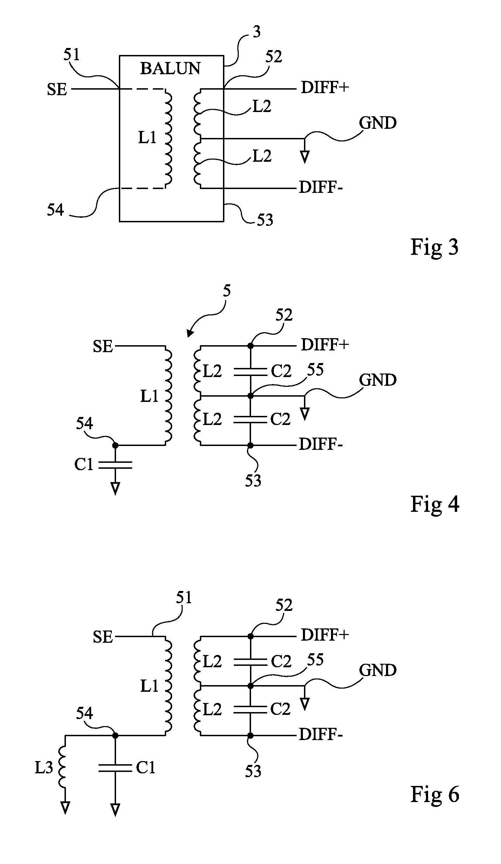

La figure 3 est un schéma d'un transformateur à changement de mode 3 (BALUN) illustrant son schéma électrique équivalent. Une première borne (port 51) de mode commun SE (single-end) est reliée par un premier élément inductif L1 à une borne 54 du coupleur par exemple laissée en l'air tandis que deux bornes (ports 52 et 53) d'accès différentiel DIFF+ et DIFF- sont reliés l'un à l'autre par deux éléments inductifs L2 de mêmes valeurs en série. Le point milieu de ces deux éléments inductifs est relié à la masse GND.

Dans une voie d'émission ou de réception, un tel balun doit être associé à un circuit d'adaptation d'impédance à la charge constituée par les circuits avals.

Pour éviter un circuit d'adaptation d'impédance, on a déjà proposé de relier la deuxième borne 54 à la masse par un condensateur (non représenté en figure 3). La valeur du condensateur est choisie en fonction du rapport d'impédance souhaité pour le balun à la fréquence utile, afin de minimiser les pertes d'insertion et en réflexion (return loss). Un exemple d'un tel balun à réglage de rapport d'impédance côté mode commun est décrit dans la demande de brevet américain US-A-2006/087384 (04/TO/229 - B6653). Le rôle du condensateur est de changer le rapport d'impédance entre les accès de mode commun et de mode différentiel, et d'ajuster la fréquence de fonctionnement du balun.

Toutefois, cette adaptation est sans effet sur une fréquence éloignée de la fréquence utile, ce qui est le cas du double ou de la moitié de cette fréquence.

Ainsi, une variation de la charge du balun côté mode commun est susceptible d'engendrer une dérive de l'oscillateur commandé en tension 471 ou 472, donc de la fréquence de la porteuse utilisée par le modulateur 46.

La figure 4 est un schéma électrique équivalent d'un mode de réalisation d'un transformateur à changement de mode 5 selon la présente invention.

Une première différence par rapport au transformateur représenté en figure 3 est la présence d'un élément capacitif C1 en série avec l'enroulement de mode commun L1 (entre le port 54 et la masse). Le rôle de ce condensateur est, comme indiqué ci-dessus, de régler le rapport d'impédance du balun à la fréquence f0 du signal utile et d'ajuster la bande de fréquences de fonctionnement.

Une autre différence est la présence, côté mode différentiel, de deux éléments capacitifs C2 de même valeur respectivement en parallèle sur les deux éléments inductifs L2. Par conséquent, chaque port 52, 53 est connecté à la masse GND par un élément capacitif C2 (en parallèle sur son élément inductif L2).

Les inventeurs ont constaté que la présence d'un condensateur en parallèle avec chaque enroulement de mode différentiel fournit une possibilité de réglage de l'impédance du transformateur à changement de mode à une fréquence différente du signal utile, sans pour autant dérégler l'adaptation du balun à la fréquence utile côté mode commun.

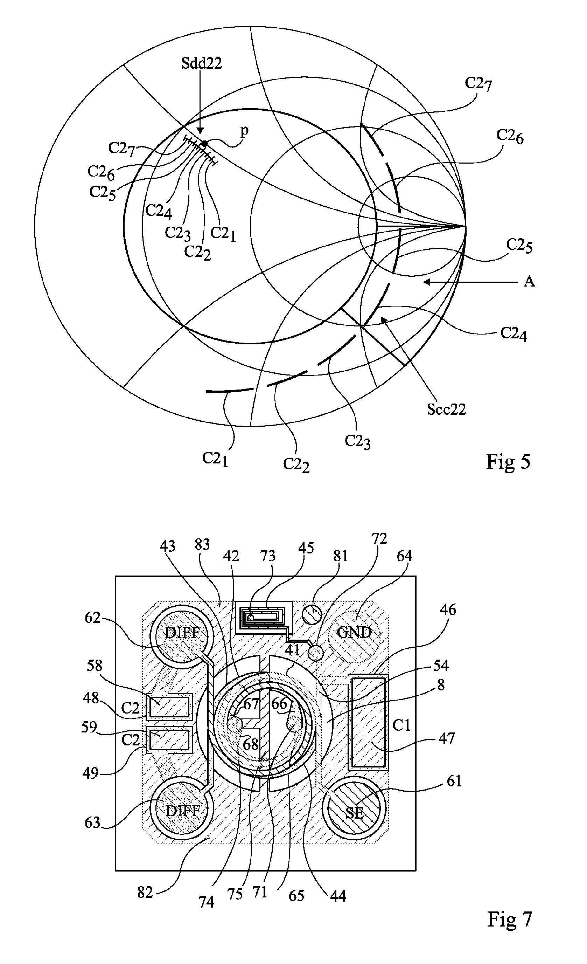

La figure 5 est un abaque de Smith illustrant le fonctionnement du balun de la figure 4 pour différentes valeurs de condensateurs C2.

Les dimensions données aux enroulements des éléments inductifs dépendent de la fréquence centrale f0 de la bande passante souhaitée pour le balun.

Le condensateur C1 est choisi en fonction du rapport d'impédance souhaité pour le transformateur à cette fréquence f0 (par exemple, de la façon décrite dans le document US-A-2006/087384 mentionné ci-dessus). Ce choix conduit à un point de fonctionnement p.

En fonction des valeurs C2₁, C2₂, C2₃, C2₄, C2₅, C2₆ et C2₇ données aux capacités C2, un paramètre Scc22, qui représente le coefficient de réflexion en sortie de mode commun lorsque l'entrée de mode différentiel est adaptée, varie. Par contre, le paramètre Sdd22, représentant le coefficient de réflexion en sortie différentielle lorsque l'entrée de mode commun est adaptée, ne varie que très peu pour les différentes valeurs du condensateur C2.

Le choix de la valeur des condensateurs C2 dépend de l'adaptation souhaitée pour l'oscillateur.

Par exemple, cette détermination de valeur s'effectue de la façon suivante :

De façon usuelle, on détermine empiriquement une zone A d'impédance souhaitée pour laquelle l'oscillateur fonctionne le mieux. On choisit alors, par simulation, les valeurs à donner aux condensateurs C2 (par exemple, soit la valeur C2₄, soit la valeur C2₅). Par exemple, on commence par attribuer une valeur nulle et on place le coefficient Scc22 sur l'abaque de Smith. Puis, on augmente progressivement la valeur jusqu'à se trouver dans la zone A. Plus la valeur des capacités C2 augmente, plus la valeur du coefficient Scc22 se déplace dans le sens des aiguilles d'une montre.

La figure 6 représente le schéma électrique d'un autre mode de réalisation d'un balun. Par rapport au mode de réalisation de la figure 4, un élément inductif L3 est monté en parallèle sur l'élément capacitif C1. Le rôle de cet élément inductif est d'apporter une protection contre les décharges électrostatiques côté mode commun. On notera que, côté mode différentiel, les éléments inductifs L2 apportent cette protection contre les décharges électrostatiques pour les éléments C2. Traditionnellement, côté mode commun, on place un élément inductif sur le port 51 (entrée SE). Un avantage de reporter l'inductance de protection électrostatique sur le port 54 est d'en diminuer la valeur en tirant profit du condensateur C1 pour former une cellule LC.

La figure 7 est une vue de dessus d'un mode de réalisation du transformateur à changement de mode de la figure 6 réalisé sous la forme d'enroulements conducteurs empilés, interdigités deux à deux, de préférence tous de même longueur choisis en fonction de la bande passante souhaitée pour le balun.

Le balun de la figure 7 est réalisé dans un empilement de trois niveaux conducteurs 81, 82 et 83 séparés par des niveaux isolants (non visibles sur la figure). Le niveau intermédiaire 82 comprend la connexion à la masse (définit un plan de masse sauf à l'aplomb des différents enroulements). Une borne 64 de connexion à la masse est, par exemple, ramenée dans le niveau supérieur 81 par un via.

L'inductance L1 de la branche de mode commun (désignée également primaire du transformateur) est formée par un enroulement plan 41 dans le premier niveau 81 (arbitrairement supérieur) entre un plot 61 externe constituant l'accès de mode commun 51 du balun et une extrémité interne 65. Par exemple, l'enroulement 41 est dans le sens inverse des aiguilles d'une montre de l'extérieur vers l'intérieur. L'extrémité interne 65 de l'enroulement 41 est reliée par un via 71 à une extrémité interne 66 d'un enroulement plan 44 formé dans le niveau 83. L'enroulement 44 définit la seconde partie de l'élément inductif L1 et tourne dans le sens inverse des aiguilles d'une montre depuis son extrémité interne 66 jusqu'à une extrémité extérieure 54. L'extrémité 54 définit le quatrième port, relié à une première électrode 46 du condensateur C1 formée dans le niveau 83. La seconde électrode 47 du condensateur C1 est le plan de masse dans le niveau 82. L'extrémité 54 est également connectée, par un via 72, à un enroulement 45 (par exemple rectangulaire) ménagé dans le niveau 81 à l'extérieur du transformateur pour définir l'inductance L3. L'enroulement 45 tourne dans le sens des aiguilles d'une montre de l'extérieur vers l'intérieur et son extrémité interne est reliée, par un via 73, au plan de masse.

Côté mode différentiel, une première des inductances L2 est couplée à l'enroulement 41 en étant réalisée sous la forme d'un enroulement conducteur plan 42 dans le premier niveau 81, interdigité avec l'enroulement 41. Ainsi, l'enroulement 42 est également dans le sens inverse des aiguilles d'une montre entre un plot 62 externe définissant l'accès de mode différentiel 52 et une extrémité centrale 67. L'extrémité 67 est reliée, par un via 74, à une extrémité interne 68 d'un enroulement 43 réalisé dans le niveau 83 en étant interdigité avec l'enroulement 44. L'extrémité externe de l'enroulement 43 est connectée, par un via, à un plot 63 dans le niveau 81 définissant l'accès 53. Par ailleurs, les extrémités internes respectives 67 et 68 des enroulements 42 et 43 sont reliées, par un pont conducteur 74 au plan de masse du niveau 82. Enfin, les extrémités externes respectives des enroulements 42 et 43 sont reliées à des premières électrodes 48 et 49 respectives des condensateurs C2 dans le niveau 83. Les secondes électrodes 58 et 59 des condensateurs C2 sont dans le plan de masse.

Le transformateur à changement de mode décrit ci-dessus est destiné à former au moins chacun des transformateurs 35 et 36 de la figure 2.

A titre d'exemple particulier de réalisation, un balun destiné à une fréquence de 2,45 Gigahertz a été réalisé avec des enroulements plans de 1 tour et demi. Le rapport d'impédance de ce balun est de 50 vers 50+j50 (impédance complexe) avec un condensateur C1 de 3,1 picofarads. Pour une fréquence d'oscillateur commandé en tension de 4,9 gigahertz, les éléments capacitifs C2 choisis ont été de 1,3 picofarads. Un tel transformateur à changement de mode réalisé selon la figure 7 occupe une surface de 1,3 par 1,2 mm².

Par rapport à un balun large bande à capacité connectée côté borne d'accès de mode commun (US-A-2008/303606 déjà mentionné), la combinaison décrite permet d'obtenir une fréquence de résonance plus élevée. De plus, on économise un via avec la connexion du condensateur entre l'enroulement de mode commun et la masse dans une réalisation intégrée.

Un avantage des modes de réalisation décrits est de limiter les dérives de l'oscillateur commandé en tension du transmetteur, en présentant une impédance optimale pour le fonctionnement de l'oscillateur.

Un autre avantage est que la présence des éléments capacitifs ne dégrade pas les performances du balun dans la bande de fréquence de fonctionnement souhaitée, définie par les longueurs des enroulements inductifs qui sont fonction du quart de longueur d'onde.

Un autre avantage est que les modes de réalisation décrits réduisent la surface globale par rapport à la surface occupée par un transformateur à changement de mode et un élément d'adaptation d'impédance.

Divers modes de réalisation ont été décrits, diverses variations et modifications apparaîtront à l'homme de l'art. En particulier, les dimensions à donner aux éléments inductifs et capacitifs et à leur surface de définition respective sont à la portée de l'homme du métier à partir des indications fonctionnelles données ci-dessus et des outils de définition et de simulation habituellement utilisés pour dimensionner des transformateurs à changement de mode. De plus, si la réalisation d'enroulements circulaires et d'un condensateur de surface carrée constitue un mode de réalisation préféré, d'autres formes sont possibles, pourvu de respecter le caractère du transformateur à changement de mode. En outre, la fabrication d'un transformateur à changement de mode en utilisant des techniques classiques en électronique de dépôt conducteur et de circuits multicouches est à la portée de l'homme du métier. Enfin, on notera que l'homme de l'art pourra combiner divers éléments de ces divers modes de réalisation et variantes sans faire preuve d'activité inventive.

## Revendications

1. Transformateur à changement de mode comportant :
côté mode commun, un élément inductif (L1) en série avec un premier élément capacitif (C1) entre une borne (SE) d'accès de mode commun et la masse (GND), ledit élément capacitif étant connecté entre ledit élément inductif et la masse ; et
côté mode différentiel, deux enroulements inductifs (L2) en série dont des premières extrémités respectives définissent des bornes (52, 53) d'accès différentiel et dont des secondes extrémités communes (55) sont connectées à la masse, et des seconds éléments capacitifs (C2) respectivement connectés en parallèle sur les enroulements de mode différentiel.

2. Transformateur selon la revendication 1, dans lequel la valeur du premier élément capacitif (C1) est choisie pour définir le rapport d'impédance, entre les accès de mode commun et de mode différentiel, à une première fréquence correspondant à la fréquence centrale (f0) de la bande passante.

3. Transformateur selon la revendication 2, dans lequel la valeur des seconds éléments capacitifs (C2) est choisie pour définir une impédance côté mode différentiel à une seconde fréquence différente de ladite première fréquence.

4. Transformateur selon l'une quelconque des revendications 1 à 3, dans lequel les éléments inductifs (L1, L2) sont réalisés sous la forme d'enroulements conducteurs plans.

5. Transformateur à changement de mode selon l'une quelconque des revendications précédentes, dans lequel les enroulements inductifs (L1, L2) sont réalisés sous la forme de plusieurs enroulements interdigités et superposés dans deux niveaux conducteurs.

6. Procédé d'utilisation d'un transformateur selon la revendication 3, dans lequel la seconde fréquence correspond à la fréquence d'un oscillateur connecté côté mode différentiel.

7. Circuit de transmission radiofréquence comportant :
au moins une voie d'émission ou de réception incluant au moins un transformateur à changement de mode (31, 32, 33, 34, 35, 36) ;
au moins un oscillateur (471, 472), **caractérisé en ce que** le transformateur à changement de mode est conforme à l'une quelconque des revendications 1 à 5.

8. Dispositif d'émission-réception comportant au moins un circuit selon la revendication 7.
